# EUROPÄISCHE PATENTSCHRIFT

(11) **EP 2 130 218 B1**
(45) Veröffentlichungstag und Bekanntmachung des Hinweises auf die Patenterteilung: **13.10.2010**
(21) Anmeldenummer: 08718232.5
(22) Anmeldetag: 26.03.2008
(51) Int. Cl.: H01L 21/8238, H01L 27/092

(54) **MASKENSPARENDE HERSTELLUNG KOMPLEMENTÄRER LATERALER HOCHVOLTTRANSISTOREN MIT RESURF-STRUKTUR**
MASK-SAVING PRODUCTION OF COMPLEMENTARY LATERAL HIGH-VOLTAGE TRANSISTORS WITH A RESURF STRUCTURE
FABRICATION À FAIBLE CONSOMMATION DE MASQUE DE TRANSISTORS HAUTE TENSION LATÉRAUX COMPLÉMENTAIRES À STRUCTURE RESURF

(30) Priorität: 26.03.2007 DE 102007016089; 23.07.2007 DE 102007034800
(43) Veröffentlichungstag der Anmeldung: 09.12.2009
(73) Patentinhaber: X-FAB Semiconductor Foundries AG, 99097 Erfurt (DE)
(72) Erfinder: ELLMERS, Christoph, 01109 Dresden (DE); UHLIG, Thomas, 01109 Dresden (DE); FÜRNHAMMER, Felix, 01109 Dresden (DE); STOISIEK, Michael, 91058 Erlangen (DE); GROSS, Michael, 90542 Eckental (DE)
(74) Vertreter: Leonhard, Frank Reimund
(86) Internationale Anmeldenummer: PCT/EP2008/053565
(87) Internationale Veröffentlichungsnummer: WO 2008/116880

(56) Entgegenhaltungen:
- EP-A- 0 741 416
- EP-A- 1 271 637
- US-A- 4 918 026
- US-A- 5 338 960
- US-A1- 2004 159 893
- US-B1- 6 451 640
- KITAMURA A ET AL: "SELF-ISOLATED AND HIGH PERFORMANCE COMPLEMENTARY LATERAL DMOSFETS WITH SURROUNDING-BODY REGIONS" PROCEEDINGS OF THE 7TH. INTERNATIONAL SYMPOSIUM ON POWER SEMICONDUCTOR DEVICES AND IC'S. (ISPSD). YOKOHAMA, MAY 23 - 25, 1995; [PROCEEDINGS OF THE INTERNATIONAL SYMPOSIUM ON POWER SEMICONDUCTOR DEVICES AND IC'S. (ISPSD)], NEW YORK, IEEE, US, Bd. SYMP. 7, 23. Mai 1995 (1995-05-23), Seiten 42-47, XP000594238 ISBN: 978-0-7803-2619-4

## Beschreibung

Die Erfindung betrifft ein Verfahren zur Herstellung eines ersten lateralen Hochvolt-MOS-Transistors und eines komplementären zweiten lateralen Hochvolt-MOS-Transistors auf einem Substrat.

Laterale Hochvolt-MOS-Transistoren mit einem n-leitfähigen Kanal werden typischerweise auf p-leitfähigen Wafern in Form eines DMOS-Transistors hergestellt, bei dem eine Topologie der Dotierungszonen der eines "doppelt diffundierten" (engl. double diffused MOS, kurz DMOS-)Transistors entspricht, wobei ein Drain-Gebiet vom gleichen Leitfähigkeitstyp ist wie eine Wannendotierung, nämlich vom n-Leitfähigkeitstyp. Laterale Hochvolt-MOS-Transistoren mit einem p-leitfähigen Kanal, also zum eben genannten Typ komplementäre laterale Hochvolt-MOS-Transistoren, werden auf p-leitfähigen Wafern typischerweise in Form eines Drain-Extension-Transistors hergestellt, bei dem Drain- und Driftgebiete vom umgekehrten Leitfähigkeitstyp sind wie die hier ebenfalls vorhandene n-Wanne. Beide Transistortypen werden im Rahmen dieser Anmeldung unter dem Begriff lateraler Hochvolt-MOS-Transistor zusammengefasst.

Die Druckschiften EP741416 und US6451640 offenbaren jeweils derartige MOS-Transistoren. Bei lateralen DMOS (LDMOS)-Transistoren für Anwendungen unter hohen elektrischen Spannungen ist es aus der US 2003/0193067 A1 (Fig. 2) bekannt, eine sogenannte Double-RESURF-Struktur zu verwenden. RESURF ist eine Abkürzung des englischen Begriffs reduced surface field, reduziertes Oberflächenfeld.

Eine Double-RESURF-Struktur enthält oberhalb und unterhalb eines Drift-Gebietes oder eines Drain-Extension-Gebiets eines LDMOS-Transistors ein Dotierungsgebiet mit einem zum Driftgebiet bzw. Drain-Extension-Gebiet entgegengesetzten Leitfähigkeitstyp. Ist beispielsweise das Driftgebiet n-leitfähig, so ist das darunter liegende Substratgebiet und das in die Driftzone eingebrachte Dotierungsgebiet der Double-RESURF-Struktur p-leitfähig. Die p-Dotierungsgebiete haben typischerweise eine Dotierstoffkonzentration in gleicher Größenordnung wie das Driftgebiet, jedoch in vertikaler Richtung integriert jeweils maximal ca. 1 * 10¹² cm⁻² Gesamtdotierung.

Mit der Double- RESURF-Struktur wird bei Anlegen einer Spannung an die Drain-Elektrode des lateralen Hochvolt-MOS-Transistors eine Verarmungszone erzeugt, die entlang der Grenze zwischen dem Driftgebiet und einem darunter liegenden Substratgebiet entgegengesetzter Leitfähigkeit verläuft. Eine weitere Verarmungszone entsteht zwischen dem unter der Oberfläche der Driftregion eingebrachten Dotierungsgebiet und der Driftregion selbst.

Auf diese Weise wird eine vollständige Verarmung des Driftgebiets an Ladungsträgern durch diese zwei in Sperrrichtung gepolten p-n-Übergänge erzeugt, was eine gewünschte Erhöhung der Durchbruchspannung des lateralen Hochvolt-MOS-Transistors bewirkt. Gleichzeitig kann durch das Einbringen des Dotierungsgebiets in das Driftgebiet die Ladungsträgerkonzentration im Driftgebiet erhöht werden, was den On-Widerstand R_{ON} des lateralen Hochvolt-MOS-Transistors reduziert. Denn für die Höhe der Durchbruchsspannung im Sperrfall ist allein die integrierte Nettodotierung des Driftgebietes und der darin eingebrachten Dotierungsgebiete entscheidend. Für diese Zwecke kompensiert das eingebrachte Dotierungsgebiet jedoch die Dotierstoffkonzentration des Driftgebiets. Es können also relativ hohe Dotierstoffkonzentrationen im Driftgebiet verwendet werden, was im Ergebnis seine Leitfähigkeit erhöht und damit R_{ON} verringert, ohne die Durchbruchsspannung zu reduzieren. Das Verfahren kann auf die Einbringung von mehreren übereinanderliegenden, voneinander getrennten p-Zonen in die Driftzone sinngemäß erweitert werden und wird dann als Multi-RESURF-Struktur oder Superjunction-Struktur bezeichnet.

Die Herstellung solcher Multiple-RESURF-Strukturen gemeinsam mit anderen Bauelementen, insbesondere komplementären Hochvolt-MOS-Transistoren, ist jedoch aufwändig und erfordert im Vergleich mit einfachen lateralen Hochvolt-MOS-Transistoren ohne Multiple-RESURF-Struktur zusätzliche Maskenschritte zur Einbringung der Dotierungsgebiete in das Driftgebiet.

Das der vorliegenden Erfindung zugrunde liegende technische Problem ist es, ein Verfahren zur Herstellung eines ersten lateralen Hochvolt-MOS-Transistors und eines dazu komplementären, zweiten lateralen Hochvolt-MOS-Transistors auf einem Substrat anzugeben, mit dem eine Double- oder Multiple-RESURF-Struktur mit besonders geringem Aufwand hergestellt werden kann.

Die Erfindung offenbart ein Verfahren gemäß Anspruch 1.

Bei dem erfindungsgemäßen Herstellungsverfahren wird ein Implantationsschritt zur Herstellung eines Drain-Extension-Gebiets im zweiten aktiven Gebiet für den zweiten lateralen Hochvolt-MOS-Transistor zur gleichzeitigen Herstellung eines ersten Dotierungsgebiets für eine Double-RESURF-Struktur im ersten lateralen Hochvolt-MOS-Transistor benutzt. Überraschenderweise gelingt es, unter identischen Implantationsbedingungen sowohl das Drain-Extension-Gebiet des zweiten lateralen Hochvolt-MOS-Transistors als auch das erste Dotierungsgebiet für die Double-RESURF-Struktur des ersten lateralen Hochvolt-MOS-Transistors in ein und demselben Implantationsschritt herzustellen. Entsprechend werden nur jeweilige Maskenöffnungen in ein und derselben Maske im Bereich des ersten und zweiten aktiven Gebiets benötigt. Auf diese Weise kann eine integrierte Schaltung, die komplementäre laterale Hochvolt-MOS-Transistoren, also laterale Hochvolt-MOS-Transistoren unterschiedlichen Leitfähigkeitstyps enthält, besonders einfach und kostengünstig hergestellt werden.

Nachfolgend werden Ausführungsbeispiele des erfindungsgemäßen Verfahrens beschrieben. Die Ausführungsbeispiele können miteinander kombiniert werden, wenn dies nicht ausdrücklich anders angegeben ist.

Das Bereitstellen des Substrats umfasst vorzugsweise das Herstellen der ersten und aktiven Gebiete vom zweiten Leitfähigkeitstyp, der dem Leitfähigkeitstyp des Substrats entgegengesetzt ist. Dies kann mit einer maskierten Implantation tiefer Wannengebiete innerhalb der aktiven Gebiete erreicht werden. Die Wannengebiete bewirken eine elektrische Isolation der lateralen Hochvolt-Transistoren vom Substrat. Beispielsweise ist der zweite Leitfähigkeitstyp die n-Leitfähigkeit, während der erste Leitfähigkeitstyp, den das Substrat aufweist, die p-Leitfähigkeit ist. Bei einem hierzu alternativen Ausführungsbeispiel des erfindungsgemäßen Verfahrens wird ein Substrat vom n-Leitfähigkeitstyp bereitgestellt und sind die Wannengebiete dementsprechend p-leitfähig.

Bei einem Ausführungsbeispiel des erfindungsgemäßen Verfahrens werden eine Vielzahl erster Dotierungsgebiete, die einen lateralen Abstand voneinander haben, hergestellt.

Bei einem weiteren Ausführungsbeispiel des erfindungsgemäßen Verfahrens werden vor dem Implantierschritt die folgenden Schritte ausgeführt:
- Ganzflächiges Abscheiden einer Maskenschicht auf dem Substrat;
- Herstellen mindestens einer ersten Maskenöffnung für die Implantation des ersten Dotierungsgebietes im ersten aktiven Gebiet und einer zweiten Maskenöffnung für die Implantation des Drain-Extension-Gebiets im zweiten aktiven Gebiet.

Bei einem weiteren Ausführungsbeispiel beinhaltet das Bereitstellen des Substrats ein Herstellen eines teilweise oder komplett mit einem elektrisch isolierenden Material gefüllten Grabens entweder nur im ersten aktiven Gebiet oder sowohl im ersten als auch im zweiten aktiven Gebiet im lateralen Bereich eines jeweiligen zukünftigen Drift-Gebietes des dort entstehenden lateralen Hochvolt-MOS-Transistors.

Bei einem weiteren Ausführungsbeispiel des erfindungsgemäßen Verfahrens erfolgt das Implantieren des Dotierstoffs in das mindestens eine erste Dotierungsgebiet durch mindestens eine erste Maskenöffnung, die, im Querschnitt des entstehenden ersten DMOS-Transistors betrachtet, eine laterale Beschränkung des ersten Dotierungsgebiets auf maximal die laterale Erstreckung des Grabens erzwingt. Die Zuordnung des Implantationsgebietes zur Grabenstruktur kann selbstjustierend bezüglich der Grabenbegrenzung erfolgen, z.B. indem die Grabenätzmaske gleichzeitig zur Maskierung der Driftzonenimplantation benutzt wird. In einer Ausführungsform dieses Ausführungsbeispiels entsteht so nach der Herstellung des Grabens durch die maskierte Implantation das erste Dotierungsgebiet im ersten aktiven Gebiet und/oder das Drain-Extension-Gebiet im zweiten aktiven Gebiet mit einer lateralen Erstreckung, die zumindest teilweise mit dem aufgefülltem Graben (wo vorhanden) überlappt oder sogar eine zu ihm identisch ist.

Bei einem weiteren Ausführungsbeispiel des erfindungsgemäßen Verfahrens umfasst das Bereitstellen des Substrats ein Herstellen des Grabens in Shallow-Trench-Technologie oder, alternativ, in LOCOS-Technologie. Der gefüllte Graben kann auch als Feldisolationsgebiet fungieren. Er wird vorzugsweise zugleich mit Feldisolationsgebieten hergestellt, die die ersten und aktiven Gebiete begrenzen.

Bei einem weiteren Ausführungsbeispiel des erfindungsgemäßen Verfahrens bildet das Herstellen des ersten Dotierungsgebiets einen Teilschritt eines übergeordneten Schritts des Herstellens einer Double-RESURF-Struktur im ersten lateralen Hochvolt-MOS-Transistor.

Bei einem weiteren Ausführungsbeispiel des erfindungsgemäßen Verfahrens werden nach dem Herstellen des ersten Dotierungsgebiets im ersten lateralen Hochvolt-MOS-Transistor und des Drain-Extension-Gebiets im zweiten lateralen Hochvolt-MOS-Transistor Source- und Drain-Gebiete im jeweiligen DMOS-Transistor hergestellt.

Bei einem weiteren Ausführungsbeispiel des erfindungsgemäßen Verfahrens wird vor dem Herstellen des ersten Dotierungsgebiets eine Gateisolationsschicht hergestellt, die lateral entweder teilweise oder ganz mit dem Graben überlappt.

Nachfolgend wird ein Ausführungsbeispiel eines erfindungsgemäßen Herstellungsverfahren anhand der beigefügten Figuren erläutert.

Es zeigen:
- Figur 1 bis Figur 15: Querschnittsansichten eines Wafers mit einem lateralen N-DMOS-Transistor, der eine Double-RESURF-Struktur aufweist, und einem lateralen P-DEMOS(P-Drain-Exten- sion **MOS**-Transistor)-Transistor in unterschiedlichen Herstellungsphasen.
- Figur 16: eine Querschnittsansicht eines Wafers mit einem latera- len n-Kanal-Hochvolt-(NDMOS)Transistor und einem la- teralen p-Kanal-Hochvolt-(PDEMOS)Transistor.

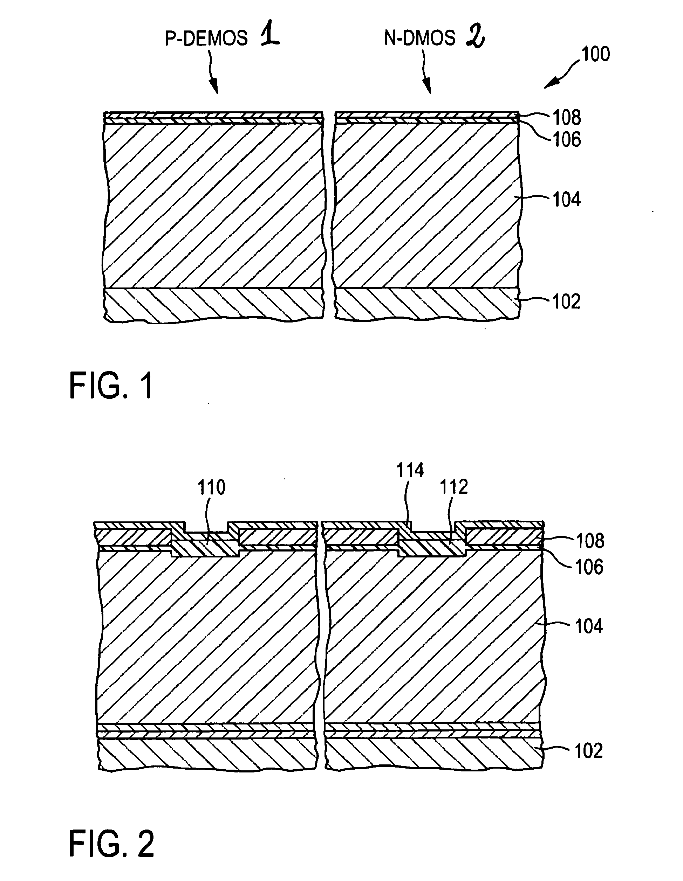

Die Figuren 1 bis 16 zeigen hergestellte Strukturen in einer rein schematischen Darstellung. Insbesondere sind die Figuren nicht dazu gedacht, tatsächlichen lateralen Erstreckungen und Tiefenerstreckungen und Grenzen der jeweiligen Strukturelemente so wiederzugeben, wie sie beispielsweise in elektronenmikroskopischen Querschnittsaufnahmen sichtbar gemacht werden könnten.

Beispielsweise sind die in den Figuren dargestellten Feldisolationsgebiete rein schematisch dargestellt. Ihre dargestellte laterale Erstreckung ist der graphischen Einfachheit halber reduziert dargestellt. Sie können relativ zu anderen Strukturelementen eine wesentlich größere laterale Erstreckung aufweisen als sie hier dargestellt ist. Diese Gestaltungsdetails sind dem Fachmann jedoch bekannt, so dass hier zur Vermittlung der wesentlichen Informationen nicht auf eine gezielt realitätsnahe, sondern auf eine komprimierte graphische Darstellung zurückgegriffen wird.

In den Figuren 1 bis 15 ist in der linken Hälfte einer jeweiligen Figur ein Stadium der Herstellung eines P-DEMOS-Transistors 1 für Hochvolt-Anwendungen, und in der rechten Hälfte ein Stadium der Herstellung eines N-DMOS-Transistors 2 für Hochvolt-Anwendungen dargestellt. Eine zwischen den Strukturen des P-DEMOS-Transistors und des N-DMOS-Transistors vertikal verlaufende, geschlängelte Linie deutet an, dass die beiden Transistoren nicht in unmittelbarer Nachbarschaft zueinander entstehen müssen. Diese zusammenhängende Darstellung ist in den Figuren 1 bis 15 nur der Einfachheit halber gewählt.

Im folgenden werden anhand der Figuren 1 bis 15 verschiedene Herstellungsphasen eines Wafers mit einem lateralen NDMOS-Transistor und einem lateralen P-DEMOS-Transistor gemäß einer beispielhaften Ausführungsform der Erfindung näher beschrieben. Die Abbildungen sind rein schematisch. Die Größenverhältnisse in dieser und in allen folgenden Figuren sind nicht der Realität entsprechend.

Figur 1 zeigt in einer Querschnittsansicht zwei Abschnitte eines vorbereiteten p+-dotierten Halbleiterwafers 102, der beispielsweise aus Silizium hergestellt ist. In einem ersten entsprechen gekennzeichneten Wafer-Abschnitt, also einem ersten, mit "NDMOS" gekennzeichneten aktiven Gebiet, wird im Laufe des nachfolgend beschriebenen Verfahrens ein N-DMOS-Transistor hergestellt, der auch als erster Hochvolt-MOS-Transistor bezeichnet wird. In einem zweiten Wafer-Abschnitt, also einem zweiten, mit "P-DEMOS" gekennzeichneten aktiven Gebiet, wird ein P-DEMOS-Transistor hergestellt, der auch als zweiter Hochvolt-MOS-Transistor bezeichnet wird.

Im dargestellten Verfahrensstadium ist eine epitaktische, p-dotierte Siliziumschicht, kurz p-Epi-Schicht 104, und darauf eine Pad-Oxid-Schicht 106 abgeschieden, die wiederum von einer Cap-Schicht 108 bedeckt ist. Eine geeignete Herstellungsart für die Pad-Oxid-Schicht 106 ist das thermische Oxidieren der Waferoberfläche. Für die Herstellung der Cap-Schicht 108 eignet sich das Aufbringen einer Siliziumnitrid-Schicht (SiN, beispielsweise in der Form Si₃N₄) mit einem CVD-Verfahren.

Figur 2 zeigt den Wafer 102 nach Abscheidung einer Gateoxid-Schicht 110 des P-DEMOS-Transistors und einer Gateoxid-Schicht 112 des N-DMOS-Transistors. Auf der gesamten dargestellten Waferoberfläche wurde weiterhin eine zweite Cap-Schicht 114 aufgebracht. Zur Herstellung der Gateoxid-Schicht 112 durch einen Lithographie-Schritt wird beispielsweise eine Ätzmaske auf der Oberfläche so strukturiert, dass die Bereiche für die Gateoxid-Schicht frei bleiben. Dann kann lokal selektiv die Gateoxid-Schicht 112 geätzt werden. Ein geeignetes Ätzverfahren ist ein nasschemisches Ätzverfahren. Im Anschluss wird die Ätzmaske entfernt, beispielsweise, indem sie unter Sauerstoff-Atmosphäre bei hoher Temperatur eingeäschert wird. Dieser Schritt ist dem Fachmann bekannt und wird in den folgenden Lithographie-Schritten nicht mehr erwähnt. Es können noch Reinigungsschritte der Gate-Bereiche folgen.

Die frei liegenden Gate-Bereiche werden danach thermisch oxidiert. Vorzugsweise wird nicht nass oxidiert, weil sich so eine dichtere Oxidschicht ergibt. Dann wird die zweite Cap-Schicht 114 aufgebracht. Dies kann durch ein CVD-Verfahren erfolgen.

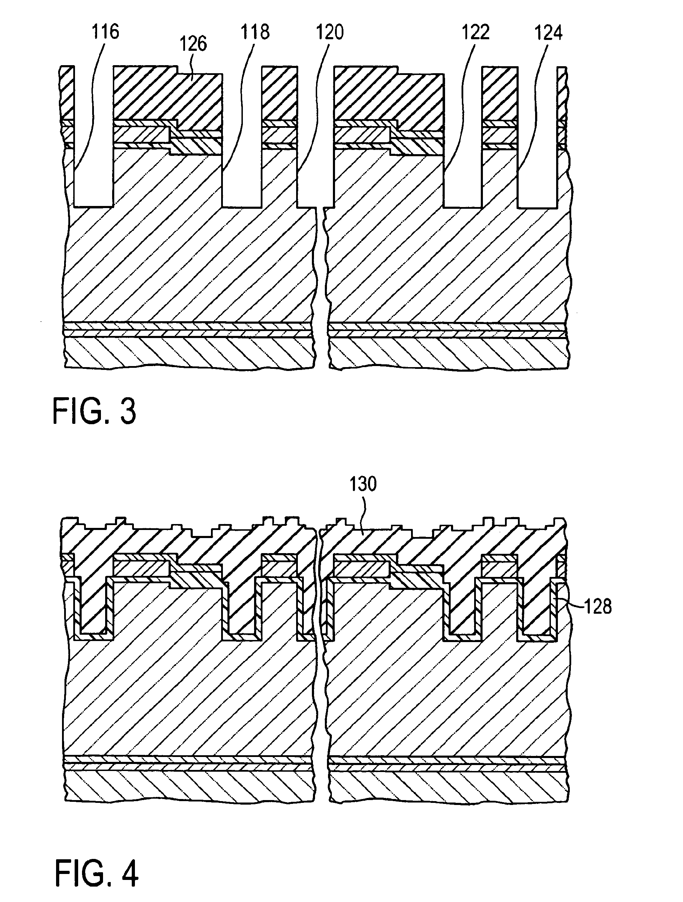

Figur 3 zeigt den Wafer 102 in einem nachfolgenden Verfahrensstadium, in dem auf der Oberfläche eine strukturierte Lithographiemaske 126 angeordnet ist. In die Waferoberfläche wurden flache Gräben 116 bis 124 eingebracht. Ein geeignetes Herstellungsverfahren für die flachen Gräben 116 bis 124 ist das reaktive Ionen-Ätzen (engl. Reaktive Ion Etching, RIE).

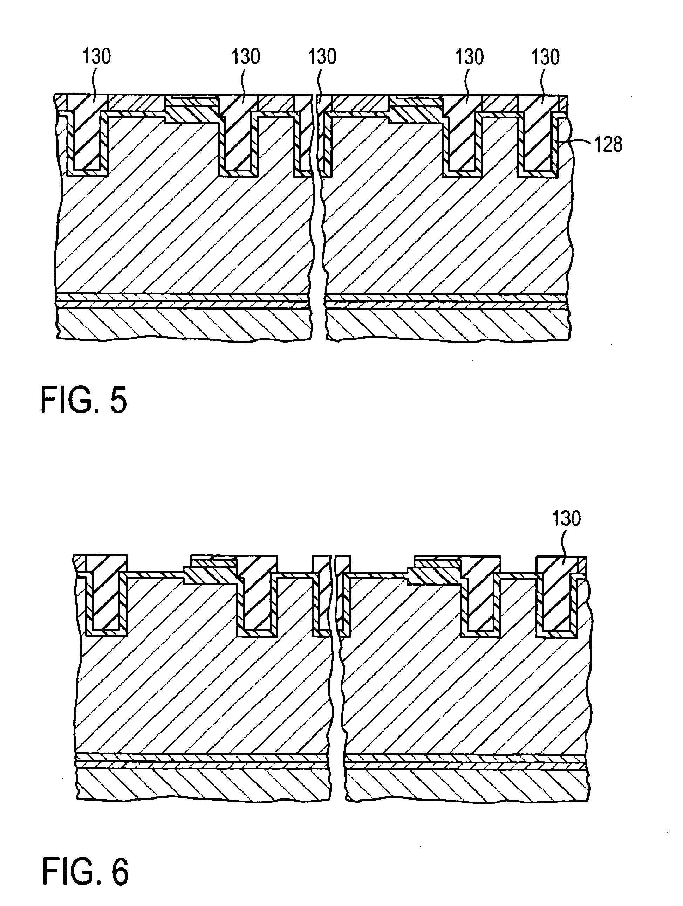

Figur 4 zeigt den Wafer in einem nachfolgenden Verfahrensstadium mit den flachen Gräben, in denen eine Liner-Oxid-Schicht 128 eingebracht ist, und darauf eine Shallow-Trench-Isolationsschicht 130, mit welcher die flachen Gräben gefüllt sind. Ein geeignetes Material für die Liner-Oxid-Schicht 128 und die Shallow-Trench-Isolationsschicht 130 ist Siliziumoxid (SiO₂) Die Liner-Oxid-Schicht 128 und die Shallow-Trench-Isolationsschicht 130 können nach dem Aufwachsen bzw. Abscheiden getempert werden. Ein geeignetes Verfahren ist High Density Plasma Deposition (hochdichtes Plasma-Abscheiden), welches sehr dichte Oxide mit guten Verfülleigenschaften erzeugt. Figur 5 zeigt den Wafer 102 in einem nachfolgenden Verfahrensstadium mit einer geglätteten Oberfläche, wobei Teile der Shallow-Trench-Isolationsschicht 130 und der zweiten Cap-Schicht 114 entfernt wurden. Ein geeignetes Verfahren zum Glätten der Oberfläche ist das Chemical-Mechanical-Polishing-Verfahren (CMP).

Figur 6 zeigt den Wafer 102 in einem darauf folgenden Verfahrensstadium, in dem weitere Abschnitte der zweiten Cap-Schicht 114 entfernt wurden. Nur zwischen der Gateoxid-Schicht 110 und einem seitlichen, über die Gateoxid-Schicht ragenden Teil der Shallow-Trench-Isolationsschicht, welcher nicht durch den CMP-Verfahrensschritt abgetragen wurde, ist die zweite Cap-Schicht 114 noch vorhanden. Die zweite Cap-Schicht 114 kann z.B. durch ein nasschemisches Ätzverfahren abgetragen werden. Als Ätzsubstanz eignet sich für eine zweite Cap-Schicht aus Siliziumnitrid z.B. ein HF-Bad.

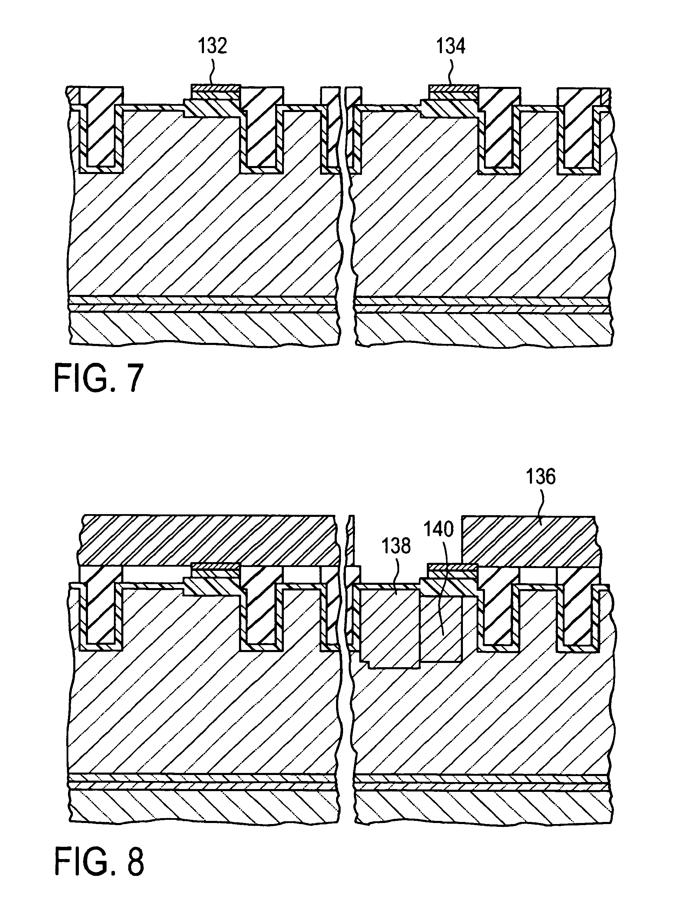

Figur 7 zeigt ein nachfolgendes Verfahrensstadium, bei dem der seitliche, über die Gateoxid-Schicht ragende Teil der Shallow-Trench-Isolationsschicht, entfernt wurde. Danach wurde eine Oxid-Schicht 132, 134 auf die selbe Stelle über der Gateoxid-Schicht 110, 112 als Opfer-Oxid-Schicht aufgebracht.

Figur 8 zeigt ein Stadium, in dem auf der Wafer-Oberfläche eine Implantationsmaske 136 aufgebracht wurde. In einem Implantationsschritt wurde ein p-Dotierungsgebiet 140 und ein p-Body 138 im aktiven Gebiet des NDMOS-Transistors erzeugt. Für die p-Dotierung eignet sich Bor (B). Zur Erzeugung eines geeigneten Dotierungsprofils in der vertikalen Richtung können mehrere Implantationsschritte bei unterschiedlichen Teilchenenergien genutzt werden.

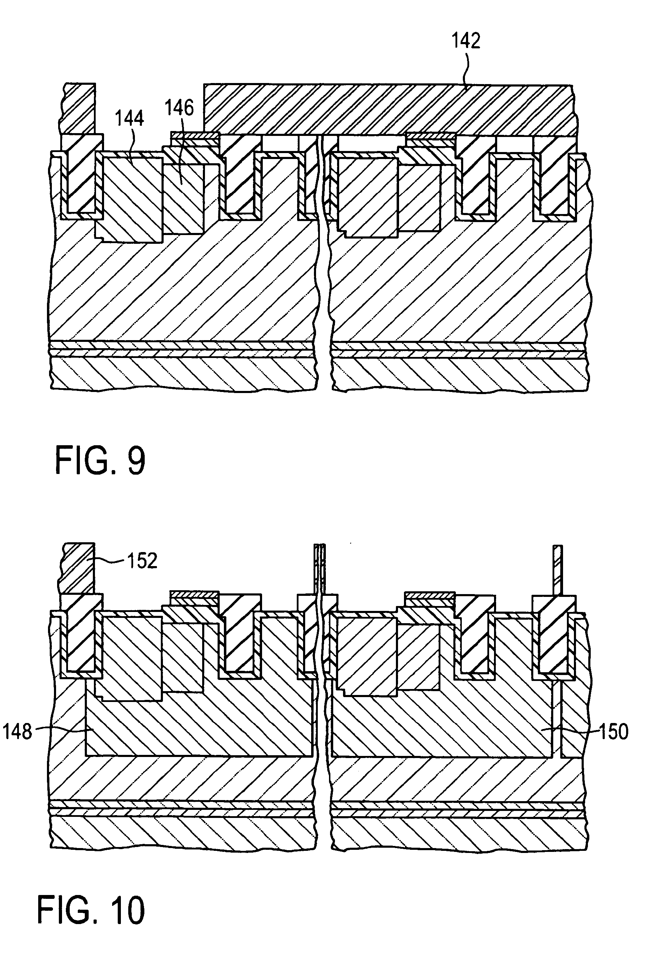

Figur 9 den Wafer 102 nach einem weiteren Implantationsschritt, bei welchem ein n-Dotierungsgebiet 146 und ein n-Bodygebiet 144 in einem zweiten aktiven Gebiet für den P-DEMOS-Transistor erzeugt wurde. Dazu wurde eine Implantationsmaske 142 photolithographisch strukturiert. Geeignete Dotierstoffe für n-Dotierung sind Arsen (As) und Phosphor (P). Auch hier können mehrere Implantationsschritte genutzt werden.

Im Verfahrensstadium der Figur 10 ist der Wafer mit einer weiteren Implantationsmaske 152 dargestellt. Durch einem weiteren Implantationsschritt wurden tiefe n-leitfähige Gräben 148 und 150 hergestellt. Durch die Verwendung mehrerer Implantationsschritte kann ein gewünschtes vertikales Dotierungsprofil mit hoher Genauigkeit hergestellt werden. Das bedeutet, dass zur Erzeugung des vertikalen Dotierungsprofils mit einer Implantationsmaske mehrmals Teilchen mit verschiedenen Eindringtiefen implantiert werden. Die Eindringtiefe ist durch die Beschleunigungsspannung der lonenquelle einstellbar. Ein geeigneter Dotierstoff ist Phosphor (P). Nach oder zwischen den Implantationsschritten können Temper-Schritte zum Ausheilen der dotierten Gebiete durchgeführt werden.

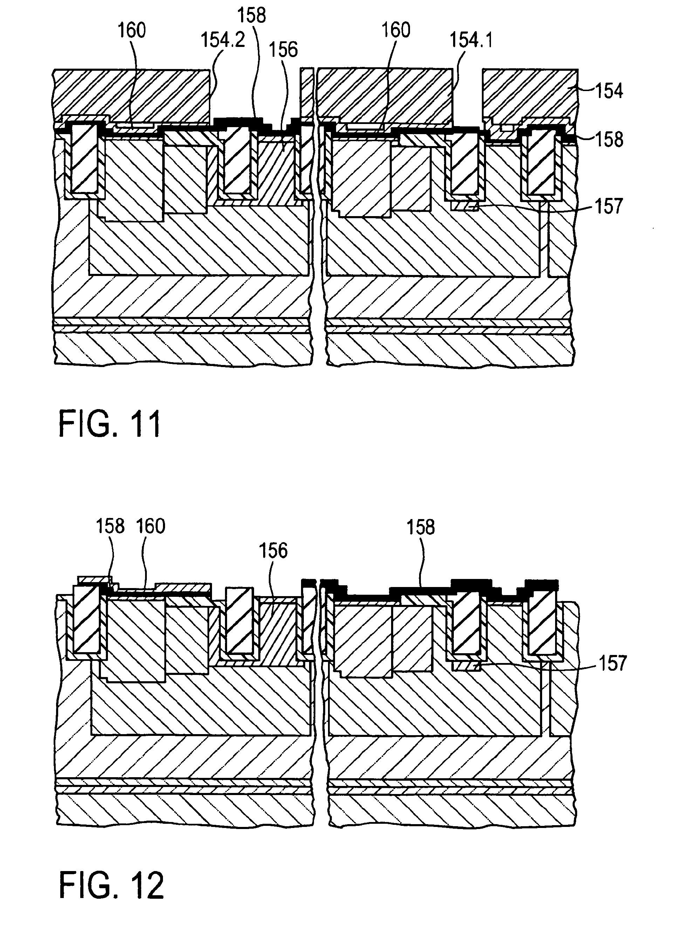

Figur 11 zeigt den Wafer 102 in einem nachfolgenden Verfahrensstadium mit einer weiteren Implantationsmaske 154, die eine erste Maskenöffnung 154.1 zur Erzeugung eines ersten Dotierungsgebietes für eine Double-RESURF-Struktur 157 und eine zweite Maskenöffnung 154.2 zur Erzeugung eines p-dotierten sich von der Substratoberfläche zum Substratinneren erstreckenden Drain-Extension-Gebiets 156 hat. Auf der Oberfläche sind eine temporäre Cap-Schicht 158 und eine Isolatorschicht 160 abgeschieden. Die Isolatorschicht 160 ist im Bereich der zwei Maskenöffnungen 154.1 und 154.2 der Implantationsmaske entfernt.

Die Herstellung des ersten Dotierungsgebietes der Double-RESURF-Struktur im NDMOS-Transistor und des Drain-Extension-Gebiets im P-DEMOS-Transistor durch gleichzeitiges Implantieren von Dotierstoff durch die jeweiligen Maskenöffnungen geschieht bei diesem Verfahren in ein und demselben Maskenschritt, also mit ein und derselben Implantationsmaske. Sowohl das erste Dotierungsgebiet als auch das Drain-Extension-Gebiet werden p dotiert. Ein geeigneter Dotierstoff ist Bor (B).

In diesem Ausführungsbeispiel wird das erste Dotierungsgebiet 157 für die Double-RESURF-Struktur ausschließlich unter einem flachen Graben 122 im ersten aktiven Gebiet des NDMOS-Transistors hergestellt. Eine erste Maskenöffnung 154.1 für die Double-RESURF-Struktur erzwingt dabei eine laterale Beschränkung des ersten Dotierungsgebiets 157 auf die laterale Erstreckung des flachen Grabens im ersten aktiven Gebiet.

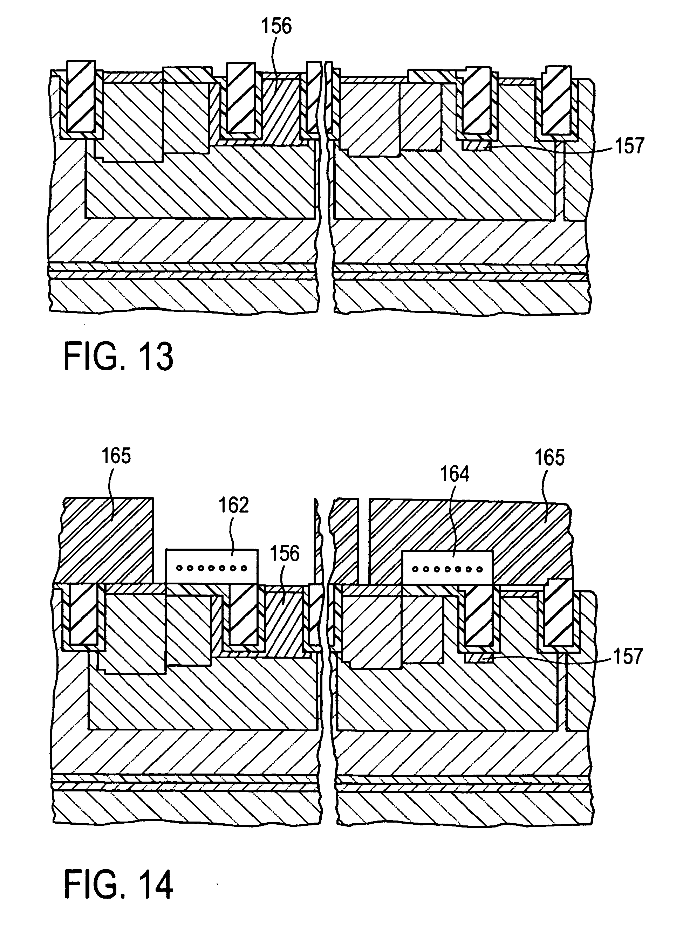

Figur 12 zeigt ein Verfahrensstadium eines nachfolgenden Zwischenschritts bei der Entfernung einer Isolatorschicht 160 und der temporären Cap-Schicht 158. Das Entfernen kann durch mehrere Schritte des selektiven Ätzens geschehen. Figur 13 zeigt die Wafer-Abschnitte nach dem vollständigen Entfernen der Isolatorschicht 160 und der temporären Cap-Schicht 158.

In einem in Figur 14 dargestellten nachfolgenden Verfahrensstadium wurde durch einen weiteren Maskenschritt eine Gateoxid-Schicht 164 für den ersten lateralen Hochvolt-Transistor und eine Gateoxid-Schicht 162 für den zweiten lateralen Hochvolt-Transistor hergestellt. Dafür kann eine Oxidschicht auf der gesamten Waferoberfläche abgeschieden werden. Danach kann mit einer Ätzmaske und einem Ätzschritt die laterale Ausdehnung der Gateoxid-Schicht 162 und 164 strukturiert werden. Die Gateoxid-Schicht wird auch als Gate-Isolationsschicht bezeichnet. In diesem Ausführungsbeispiel überlappt die Gate-oxid-Schicht 162, 164 die flachen Gräben 118 und 122.

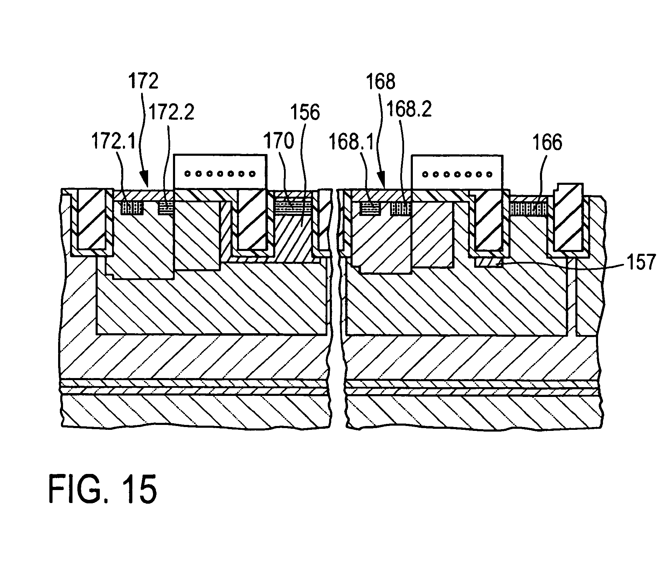

In dieser Figur ist auch eine photolithographisch strukturierte Implantationsmaske 165 auf den Wafer-Abschnitten dargestellt. Diese Implantationsmaske 165 dient zur Implantation der in Figur 15 dargestellten p-dotierten Source/Drain-Gebiete des P-DEMOS-Transistors und eines p-Dotierungsgebiets des Source-Gebiets des N-DMOS-Transistors.

Figur 15 zeigt die lateralen Hochvolt-Transistoren 1, 2 nach Fertigstellung der Source-Gebiete 168 und 172 und der Drain-Gebiete 166 und 170. Die Source- und Drain-Gebiete 168 und 172 werden mit zwei Implantationsschritten mit zwei strukturierten Implantationsmasken hergestellt, von denen die Implantationsmaske zur Dotierung der p-dotierten Gebiete in Figur 14 dargestellt ist. Eine weitere Implantationsmaske mit entsprechenden Maskenöffnungen wird für die Herstellung des n-Dotierungsgebiets des Source-Gebiets 172.1 des P-DEMOS-Transistors, des n-Dotierungsgebiets des Source-Gebiets 168.2 des N-DMOS-Transistors und des Drain-Gebiets 166 des N-DMOS-Transistors verwendet.

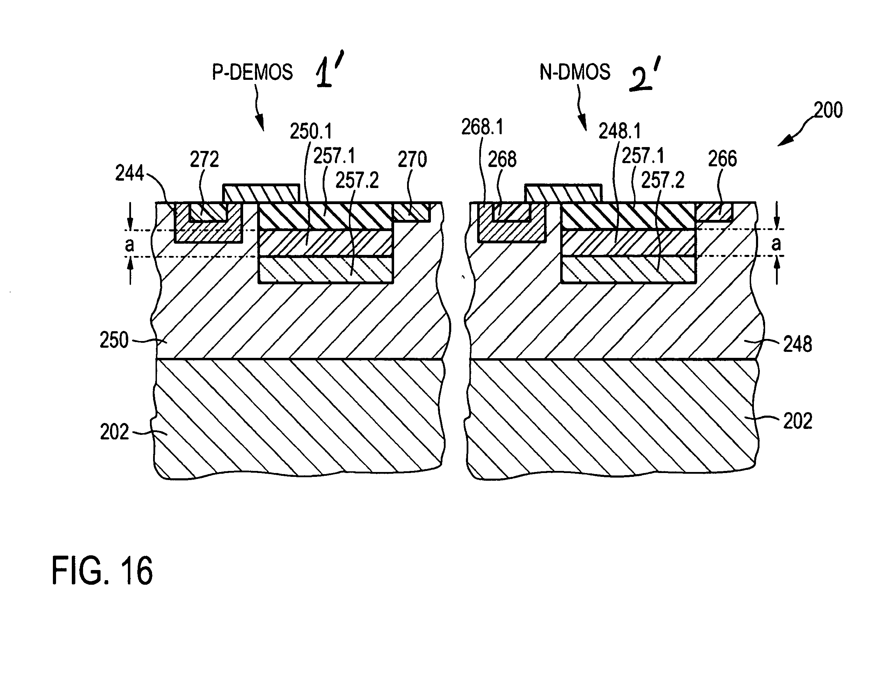

Figur 16 zeigt schematisch eine Querschnittsansicht eines Wafers mit einem lateralen n-Kanat-Hochvolt-(N-DMOS)-Transistor 2' und einem lateralen p-Kanal-Hochvolt-(PDEMOS)-Transistor 1'.

Es sind zwei Abschnitte eines Halbleiterbauelements 200, welches auf einem p+-Water 102 hergestellt wurde, dargestellt. Ein erster Wafer-Abschnitt enthält den N-DMOS-Transistor 2' in einem ersten aktiven Gebiet und ist wieder entsprechend mit "N-DMOS" gekennzeichnet. Ein zweiter Abschnitt enthält den P-DEMOS-Transistor 1' in einem zweiten aktiven Gebiet und ist mit "P-DEMOS" gekennzeichnet.

Der N-DMOS-Transistor ist in einem tiefen n-leitfähigen Graben 248, der auch als n-Wanne bezeichnet wird, ausgebildet. Er enthält ein Drain-Gebiet 266, ein Source-Gebiet 268 und ein Driftgebiet 248.1. Oberhalb und unterhalb des Driftgebietes 248.1 der Höhe a befinden sich RESURF-Dotierungsgebiete 257.1 und 257.2 für eine Double-RESURF-Struktur. Der Driftgebietabschnitt 248.1 ist dabei n-dotiert und die RESURF-Dotierungsgebiete 257.1 und 257.2 sind p-dotiert. Die RESURF-Dotierungsgebiet 257.1 und 257.2 werden nach Anspruchswortlaut auch als erste Dotierungsgebiete bezeichnet.

Weiterhin ist um das Source-Gebiet des N-DMOS-Transistors ein p-dotiertes Body-Implantationsgebiet 268.1, dass auch als p-Bodygebiet bezeichnet wird, implantiert.

Der zweite Wafer-Abschnitt enthält den zweiten lateralen Hochvolt-Transistor 1'. Dieser Transistor enthält ein Source-Gebiet 272 ein Drain-Gebiet 270, einen tiefen n-leitfähigen Graben 250, der auch als n-Wanne bezeichnet wird, und um das Source-Gebiet ein n-dotiertes Body-Implantationsgebiet 244. Weiterhin enthält der laterale P-DEMOS-Transistor einen Driftgebiet-Abschnitt 250.1. Oberhalb des Driftgebiet-Abschnitts 250.1 befindet sich ein Abschnitt des Drain-Extension-Gebiets 257.1.

Das Drain-Extension-Gebiet 257.1 zusammen mit dem Driftgebiet-Abschnitt 250.1 und einem darunter liegenden p-dotierten Abschnitt 257.2 haben das selbe vertikale Dotierungsprofil im P-DEMOS-Transistor wie die Double-RESURF-Struktur im N-DMOS-Transistor bestehend aus den RESURF-Dotierungsgebieten 257.1, 257.2 im N-DMOS-Transistor und dem Driftgebiet-Abschnitt 248.1. Der Driftgebiet-Abschnitt 250.1 kann auch als "RESURF-Dotierungsgebiet im P-DEMOS" bezeichnet werden.

Deshalb erfolgt die Herstellung des Drain-Extension-Gebiets 257.1 im P-DEMOS-Transistor und der Double RESURF-Struktur im N-DMOS Transistor mit einem einzigen Maskenschritt, dass heißt mit ein und der selben Implantationsmaske. Hierbei werden sequenziell die p-dotierten Abschnitte 257.1 und 257.2 und die n-dotierten Abschnitte 248.1 und 250.1 hergestellt. Der Vorteil dieses Verfahrens ist, dass die Double-RESURF-Struktur im N-DMOS-Transistor gleichzeitig mit den Abschnitten des Drain-Extension-Gebiets im P-DEMOS-Transistor hergestellt werden. Das vertikale Dotierungs-Profil des Drain-Extension-Gebiets und des Driftgebiet-Abschnitts im P-DEMOS-Transistor sowie die Double-RESURF-Struktur im N-DMOS-Transistor enthält abwechselnd p- und n-dotierte vergrabene, oberflächenparallele Schichten 257.1, 248.1 und 257.2 bzw. 257.1, 250,1 und 257.2.

Die vorstehend beschriebenen Ausführungsbeispiele sollen nicht einschränkend verstanden werden, sondern können im Rahmen des von den Ansprüchen definierten Schutzumfangs variiert werden.

### Bezugszeichenliste

Figuren 1 bis 15
   - 100: Halbleiterbauelement
   - PDEMOS: P-DEMOS-Transistor 1
   - NDMOS: N-DMOS-Transistor 2
   - 102: p+-Wafer (z.B. Silizium)
   - 104: p-Epi-Schicht (z.B. Silizium)
   - 106: Pad-Oxid-Schicht (z.B. Thermisches SiO₂)
   - 108: Cap-Schicht (z.B. Siliziumnitrid).
   - 110: Gateoxid-Schicht des P-DEMOS-Transistors
   - 112: Gateoxid-Schicht des N-DMOS-Transistors
   - 114: zweite Cap-Schicht (z.B. Siliziumnitrid)
   - 116 bis 124: flache Gräben
   - 126: Lithographiemaske
   - 128: Liner-Oxid-Schicht
   - 130: Shallow-Trench-Isolationsschicht (z.B. SiO₂)
   - 132: Oxid-Schicht
   - 134: Oxid-Schicht
   - 136: Implantationsmaske
   - 138: p-dotiertes Body-Implantationsgebiet, auch als p-Bodygebiet bezeichnet
   - 140: p-Dotierungsgebiet
   - 142: Implantationsmaske
   - 144: n-dotiertes Body-Implantationsgebiet, auch als n-Bodygebiet bezeichnet
   - 146: n-Dotierungsgebiet
   - 148: tiefer n-leitfähiger Graben
   - 150: tiefer n-leitfähiger Graben
   - 152: Implantationsmaske
   - 154: Implantationsmaske
   - 154.1: erste Maskenöffnung für Double-RESURF-Struktur
   - 154.2: zweite Maskenöffnung für p-dotiertes Drain-Extension-Gebiet
   - 156: p-dotiertes Drain-Extension-Gebiet
   - 157: erstes Dotierungsgebiet für Double-RESURF-Struktur
   - 158: temporäre Cap-Schicht
   - 160: Isolatorschicht
   - 162: Gate-Oxid-Schicht
   - 164: Gate-Oxid-Schicht
   - 165: Implantationsmaske
   - 166: Drain-Gebiet des N-DMOS-Transistors
   - 168: Source-Gebiet des N-DMOS-Transistors
   - 168.1: p-Dotierungsgebiet des Source-Gebiets
   - 168.2: n-Dotierungsgebietes Source-Gebiets
   - 170: Drain-Gebiet des P-DEMOS-Transistors
   - 172: Source-Gebiet des P-DEMOS-Transistors
   - 172.1: n-Dotierungsgebiet des Source-Gebiets
   - 172.2: p-Dotierungsgebiet des Source-Gebiets.
Figur 16
   - 200: Halbleiterbauelement
   - PDEMOS: P-DEMOS-Transistor 1'
   - NDMOS: N-DMOS-Transistor 2'
   - 202: p+-Wafer (z.B. Silizium)
   - 244: n-dotiertes Body-Implantationsgebiet, auch als n-Bodygebiet bezeichnet
   - 248: tiefer n-leiffähiger Graben, auch als n-Wanne bezeichnet
   - 248.1: Driftgebiet-Abschnitt im N-DMOS-Transistor
   - 250: tiefer n-leitfähiger Graben, auch als n-Wanne bezeichnet
   - 250.1: Driftgebiet im P-DEMOS-Transistor
   - 257.1, 257.2: RESURF-Dotierungsgebiete für Double-RESURF-Struktur im N-DMOS sowie zugleich Abschnitte des Drain-Extension-Gebiets (Driftgebiets) im P-DEMOS-Transistor
   - 266: Drain-Gebiet des N-DMOS-Transistors
   - 268: Source-Gebiet des N-DMOS-Transistors
   - 268.1: p-dotiertes Body-Impiantationsgebiet, auch als p-Bodygebiet bezeichnet.
   - 270: Drain-Gebiet des P-DEMOS-Transistors
   - 272: Source-Gebiet des P-DEMOS-Transistor

## Patentansprüche

1. **Verfahren zur Herstellung** eines ersten lateralen Hochvolt-MOS-Transistors (2,2') und eines zweiten, zum ersten komplementären lateralen Hochvolt-MOS-Transistors (1,1') auf einem Substrat (102), wobei der erste und zweite laterale Hochvolt-MOS-Transistor jeweils ein Driftgebiet aufweist, das Verfahren mit den Schritten
- Bereitstellen eines Substrats (102;202) eines ersten Leitfähigkeitstyps mit einem ersten aktiven Gebiet für den ersten lateralen Hochvolt-MOS-Transistor (2,2') und einem zweiten aktiven Gebiet für den komplementären Hochvolt-MOS-Transistor (1,1'), wobei die beiden aktiven Gebiete einen zweiten Leitfähigkeitstyp besitzen;
- Herstellen mindestens eines ersten Dotierungsgebiets (157;257.1,257.2) des ersten Leitfähigkeitstyps im ersten aktiven Gebiet und im zweiten aktiven Gebiet eines sich von einer Substratoberfläche zu einem Substratinneren erstreckenden Drain-Extension-Gebiets durch ein gleichzeitiges Implantieren von Dotierstoff durch jeweilige Maskenöffnungen (154.1,154.2) ein und derselben Maske (154) in das erste und zweite aktive Gebiet;
**dadurch gekennzeichnet, dass**
- das Herstellen des ersten Dotierungsgebiets der ersten Leitfähigkeit einen Teilschritt eines übergeordneten Herstellens einer Double-RESURF-Struktur des ersten lateralen Hochvolt-MOS-Transistors (2,2') bildet und das Herstellen der Double-RESURF-Struktur das Herstellen der RESURF-Dotierungsgebiete in Form zweier erster Dotierungsgebiete (257.1,257.2) jeweils oberhalb und unterhalb eines Drift-Gebiets (248.1) des ersten Transistors (2,2') umfasst, wobei die RESURF-Dotierungsgebiete (257.1, 257.2) und das Drain-Extension-Gebiet (250.1) im zweiten Transistor (1,1') durch die jeweiligen Maskenöffnung(en) derselben Maske (154) implantiert werden.

2. Verfahren nach Anspruch 1, bei dem im ersten aktiven Gebiet eine Vielzahl erster Dotierungsgebiete, die einen lateralen Abstand voneinander haben, hergestellt werden.

3. Verfahren nach Anspruch 1 oder 2, mit vor dem Implantierschritt ausgeführten Schritten
- Ganzflächiges Abscheiden einer Maskenschicht (154) auf dem Substrat;
- Herstellen mindestens einer ersten Maskenöffnung (154.1) für die Implantation des ersten Dotierungsgebietes im ersten aktiven Gebiet und einer zweiten Maskenöffnung (154.2) für die Implantation des Drain-Extension-Gebiets im zweiten aktiven Gebiet.

4. Verfahren nach einem der vorstehenden Ansprüche, bei dem das Bereitstellen des Substrats ein Herstellen eines teilweise oder komplett mit einem elektrisch isolierenden Material gefüllten Grabens (130) entweder nur im ersten aktiven Gebiet oder sowohl im ersten als auch im zweiten aktiven Gebiet im lateralen Bereich eines jeweiligen zukünftigen Drift-Gebietes des dort entstehenden lateralen Hochvolt-MOS-Transistors umfasst.

5. Verfahren nach Anspruch 4, bei dem das erste Dotierungsgebiet (157) des ersten Leitfähigkeitstyps ausschließlich unter dem Graben (130) hergestellt wird.

6. Verfahren nach Anspruch 4 oder 5, bei dem das Implantieren des Dotierstoffs in das mindestens eine erste Dotierungsgebiet (157) durch mindestens eine erste Maskenöffnung (154.1) erfolgt, die - im Querschnitt des entstehenden ersten lateralen Hochvolt-MOS-Transistors betrachtet - eine laterale Beschränkung des ersten Dotierungsgebiets auf maximal die laterale Erstreckung des Grabens erzwingt.

7. Verfahren nach einem der vorstehenden Ansprüche, bei dem ein Substrat (102;202) vom p-Leitfähigkeitstyp bereitgestellt wird.

8. Verfahren nach einem der Ansprüche 1 bis 6, bei dem ein Substrat (102;202) vom n-Leitfähigkeitstyp bereitgestellt wird.

9. Verfahren nach einem der vorstehenden Ansprüche, bei dem das Bereitstellen des Substrats ein laterales Abgrenzen der aktiven Gebiete durch Feldisolationsgebiete (130) umfasst.

10. Verfahren nach einem der vorstehenden Ansprüche in Kombination mit Anspruch 4, bei dem das Bereitstellen des Substrats ein Herstellen des Grabens (130) in Shallow-Trench-Technologie gleichzeitig mit den Feldisolationsgebieten umfasst.

11. Verfahren nach Anspruch 4, bei dem vor Herstellen des ersten Dotierungsgebiets eine Gate-Isolationsschicht (162, 164) hergestellt wird, die lateral entweder teilweise oder ganz mit dem Graben (130) überlappt.

12. Verfahren nach einem der vorstehenden Ansprüche, bei dem das Herstellen des mindestens einen ersten Dotierungsgebiets (257.1,257.2) im ersten aktiven Gebiet und des Drain-Extension-Gebiets im zweiten aktiven Gebiet eine Sequenz von Implantationsschritten mit n-Dotierstoffen und p-Dotierstoffen unterschiedlicher Implantationsenergie umfasst, womit eine vertikale Schichtfolge abwechselnd p- und n-dotierter oberflächen-paralleler Schichten entsteht.

13. Verfahren nach einem der vorstehenden Ansprüche, bei dem nach dem Herstellen des ersten Dotierungsgebiets (157) im ersten lateralen Hochvolt-MOS-Transistor und des Drain-Extension-Gebiets (156) im zweiten lateralen Hochvolt-MOS-Transistor Source- und Drain-Gebiete (166, 168, 170, 172) im jeweiligen lateralen Hochvolt-MOS-Transistor hergestellt werden.

## Claims

1. Process for producing a first lateral high-voltage MOS transistor (2, 2') and a second lateral high-voltage MOS transistor (1, 1') which is complementary to the first on a substrate (102), wherein the first and second lateral high-voltage MOS transistor in each case has a drift region in the particular active region, the process having the steps
- provision of a substrate (102; 202) of a first conductivity type with the first active region for the first lateral high-voltage MOS transistor (2, 2') and the second active region for the complementary high-voltage MOS transistor (1, 1');
- production of at least one first doping region (157; 257.1, 257.2) of the first conductivity type in the first active region and in the second active region of a drain extension region of the first conductivity type extending from one substrate surface to a substrate interior by simultaneous implanting of doping material through particular mask openings (154.1, 154.2) of one and the same mask (154) into the first and second active region;
- wherein the production of the first doping region of the first conductivity forms a part step of a superordinate production of a double RESURF structure of the first lateral high-voltage MOS transistor (2, 2') and the production of the double RESURF structure comprises the production of the RESURF doping regions in the form of two first doping regions (257.1, 257.2) in each case above and below a drift region (248.1) of the first transistor (2, 2'), wherein the RESURF doping regions (257.1, 257.2) and the drain extension region (250.1) are implanted by the particular mask opening(s) of the same mask (154).

2. Process according to claim 1, in which a plurality of first doping regions, which have a lateral distance from one another, are produced in the first active region.

3. Process according to claim 1 or 2, having steps executed before the implanting step
- whole-surface deposition of a mask layer (154) on the substrate;
- production of at least one first mask opening (154.1) for the implantation of the first doping region in the first active region and a second mask opening (154.2) for implantation of the drain extension region in the second active region.

4. Process according to one of the above claims, in which the provision of the substrate comprises production of a trench (130) filled partly or completely with an electrically insulating material either only in the first active region or both in the first and in the second active region in the lateral area of a particular future drift region of the lateral high-voltage MOS transistor being produced there.

5. Process according to claim 4, in which the first doping region (157) of the first conductivity type is produced exclusively below the trench (130).

6. Process according to claim 4 or 5, in which the implanting of the doping material into the at least one first doping region (157) is effected by at least one first mask opening (154.1), which forces a lateral restriction of the first doping region to at most the lateral extension of the trench - viewed in cross-section of the resulting first lateral high-voltage MOS transistor.

7. Process according to one of the above claims, in which a substrate (102; 202) is provided by the p-conductivity type.

8. Process according to one of claims 1 to 6, in which a substrate (102; 202) is provided by the n-conductivity type.

9. Process according to one of the above claims, in which the provision of the substrate comprises lateral demarcation of the active regions by field insulation regions (130).

10. Process according to one of the above claims in combination with claim 4, in which the provision of the substrate comprises production of the trench (130) by shallow-trench technology at the same time as the field insulation regions.

11. Process according to claim 4, in which before production of the first doping region, a gate insulation layer (162, 164) is produced which overlaps laterally either partly or completely with the trench (130).

12. Process according to one of the above claims, in which the production of the at least one first doping region (257.1, 257.2) in the first active region and of the drain extension region in the second active region comprises a sequence of implantation steps with n-doping materials and p-doping materials of different implantation energy, with which a vertical layer sequence of alternating p-doped and n-doped surface-parallel layers is produced.

13. Process according to one of the above claims, in which after production of the first doping region (157) in the first lateral high-voltage MOS transistor and of the drain extension region (156) in the second lateral high-voltage MOS transistor, source regions and drain regions (166, 168, 170, 172) are produced in the particular lateral high-voltage MOS transistor.

## Revendications

1. Procédé pour la fabrication d'un premier transistor MOS haute tension latéral (2, 2') et d'un deuxième transistor MOS haute tension latéral (1, 1') complémentaire au premier sur un substrat (102), dans lequel le premier et le deuxième transistors MOS haute tension latéraux présentent chacun une zone de dérive dans la zone active respective, le procédé présentant les étapes suivantes:
- préparer un substrat (102; 202) d'un premier type de conductivité avec la première zone active pour le premier transistor MOS haute tension latéral (2, 2') et avec la deuxième zone active pour le transistor MOS haute tension complémentaire (1, 1');
- fabriquer au moins une première zone de dopage (157; 257.1, 257.2) du premier type de conductivité dans la première zone active et dans la deuxième zone active d'une zone d'extension de drain du premier type de conductivité s'étendant d'une surface du substrat à un intérieur du substrat par une implantation simultanée de substance dopante à travers des ouvertures de masque respectives (154.1, 154.2) d'un seul et même masque (154) dans la première et la deuxième zones actives;
- dans lequel la fabrication de la première zone de dopage du premier type de conductivité forme une étape partielle d'une fabrication prioritaire d'une structure RESURF Double du premier transistor MOS haute tension latéral (2, 2') et la fabrication de la structure RESURF Double comprend la fabrication des zones de dopage RESURF sous la forme de deux premières zones de dopage (257.1, 257.2) respectivement au-dessus et en dessous d'une zone de dérive (248.1) du premier transistor (2, 2'), dans lequel les zones de dopage RESURF (257.1, 257.2) et la zone d'extension de drain (250.1) sont implantées à travers les ouvertures de masque respectives du même masque (154).

2. Procédé selon la revendication 1, dans lequel on fabrique dans la première zone active une multiplicité de premières zones de dopage, qui présentent une distance latérale entre elles.

3. Procédé selon la revendication 1 ou 2, comprenant les étapes suivantes effectuées avant l'étape d'implantation:
- dépôt d'une couche de masque (154) sur toute la surface du substrat;
- fabrication d'au moins une première ouverture de masque (154.1) pour l'implantation de la première zone de dopage dans la première zone active et d'une deuxième ouverture de masque (154.2) pour l'implantation de la zone d'extension de drain dans la deuxième zone active.

4. Procédé selon l'une quelconque des revendications précédentes, dans lequel la préparation du substrat comprend une fabrication d'une fosse (130) partiellement ou entièrement remplie d'un matériau électriquement isolant soit seulement dans la première zone active soit aussi bien dans la première que dans la deuxième zone active dans la zone latérale d'une future zone de dérive respective du transistor MOS haute tension latéral apparaissant à cet endroit.

5. Procédé selon la revendication 4, dans lequel on fabrique la première zone de dopage (157) du premier type de conductivité exclusivement en dessous de la fosse (130).

6. Procédé selon la revendication 4 ou 5, dans lequel l'implantation de la substance dopante dans ladite au moins une première zone de dopage (157) est effectuée à travers au moins une première ouverture de masque (154.1), qui - considérée en section transversale du premier transistor MOS haute tension latéral qui apparaît - impose une limitation latérale de la première zone de dopage au maximum à l'extension latérale de la fosse.

7. Procédé selon l'une quelconque des revendications précédentes, dans lequel on prépare un substrat (102; 202) du type de conductivité p.

8. Procédé selon l'une quelconque des revendications 1 à 6, dans lequel on prépare un substrat (102; 202) du type de conductivité n.

9. Procédé selon l'une quelconque des revendications précédentes, dans lequel la préparation du substrat comprend une limitation latérale des zones actives par des zones d'isolation de champ (130).

10. Procédé selon l'une quelconque des revendications précédentes en combinaison avec la revendication 4, dans lequel la préparation du substrat comprend une fabrication de la fosse (130) par la technologie Shallow-Trench en même temps que les zones d'isolation de champ.

11. Procédé selon la revendication 4, dans lequel, avant la fabrication de la première zone de dopage, on fabrique une couche d'isolation de grille (162, 164), qui recouvre latéralement la fosse (130), soit partiellement soit entièrement.

12. Procédé selon l'une quelconque des revendications précédentes, dans lequel la fabrication de ladite au moins une première zone de dopage (257.1, 257.2) dans la première zone active et de la zone d'extension de drain dans la deuxième zone active comprend une séquence d'étapes d'implantation avec des substances dopantes n et des substances dopantes p d'énergie d'implantation différente, par laquelle il apparaît une succession verticale de couches parallèles à la surface dopées alternativement p et n.

13. Procédé selon l'une quelconque des revendications précédentes, dans lequel, après la fabrication de la première zone de dopage (157) dans le premier transistor MOS haute tension latéral et de la zone d'extension de drain (156) dans le deuxième transistor MOS haute tension latéral, on fabrique des zones de source et de drain (166, 168, 170, 172) dans le transistor MOS haute tension latéral respectif.
